# EUROPEAN PATENT SPECIFICATION

(11) **EP 3 130 035 B1**
(45) Date of publication and mention of the grant of the patent: **29.08.2018**
(21) Application number: 15716687.7
(22) Date of filing: 02.04.2015
(51) Int. Cl.: H01Q 1/24, H01Q 7/00, H01Q 9/04, H01Q 9/42, H01Q 1/48

(54) **HEAD-HAND CAPACITANCE COMPENSATION WITH DIGITAL VARIABLE CAPACITOR**
KOPF-HAND-KAPAZITÄTSAUSGLEICH MIT DIGITALEM VARIABLEM KONDENSATOR
COMPENSATION DE CAPACITÉ TÊTE-MAIN AVEC UN CONDENSATEUR NUMÉRIQUE VARIABLE

(30) Priority: 07.04.2014 US 201461976469 P
(43) Date of publication of application: 15.02.2017
(73) Proprietor: Cavendish Kinetics, Inc., San Jose, CA 95134 (US)
(72) Inventor: PARKHURST, Ray, Santa Clara, California 95051 (US); TORNATTA, Paul Anthony, Jr., Melbourne, Florida 32940 (US)
(74) Representative: Gill Jennings & Every LLP
(86) International application number: PCT/US2015/024107
(87) International publication number: WO 2015/157087

(56) References cited:
- US-A1- 2013 217 342
- US-A1- 2014 071 008

## Description

Embodiments of the present disclosure generally relate to a device, such as a cell phone, with a feedback system that compensates for the capacitance change that occurs when a cell phone is held in the hand or adjacent the head of a user.

Cellular phones, such as mobile phones, have many desirable features that make everyday life easier. For instance, mobile phone can receive emails, text messages and other data for the end user to utilize. Additionally, the mobile phone can send emails, text messages and other data from the mobile phone. The mobile phone typically operates on a wireless network provided by any one of the various cell phone carriers. The data sent to and from the mobile phones require the mobile phone to operate at an increasing number of frequencies to support all of the components and antennas of the mobile phone.

The issue with mobile phones is that when the phone is held in the hand or placed near the ear for talking, the head and hand can affect the device performance by interfering with the antenna. In fact, upon release of one mobile phone where antenna interference was a well documented problem, it was remarked that "You're holding it wrong" in regards to the mobile phone. In other words, simply by holding the phone, the antenna performance worsened. The antenna performance problem has continued to this day.

Therefore, there is a need in the art for a device and method whereby a user's hand and/or head does not negatively impact the device's performance. US2013/217342 and US2014/071008 both disclose devices for the control of an antenna and source coupled thereto together with a capacitive sensor.

The present disclosure generally relates to a device having a capacitance sensor that detects a change in capacitance that occurs in the antenna whenever the antenna is in close proximity to a user's hand and/or head. Following detection of the capacitance change, the capacitance of the antenna may be changed by using a variable capacitor that is coupled to the sensor through a controller.

According to an aspect of the invention, there is provided a device according to claim 1.

According to another aspect of the invention, there is provided a method according to claim 11.

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments.
Figure 1 is an isometric illustration of a mobile phone according to one embodiment.
Figure 2A is a schematic top illustration of a digital variable capacitor according to one embodiment.
Figure 2B is a schematic cross-sectional illustration taken along line A-A of Figure 2A.
Figures 3A-3B are schematic circuit diagrams of the device capable of compensating for hand and/or head interference with antenna operation.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

The present disclosure generally relates to a device having a capacitance sensor that detects a change in capacitance that occurs in the antenna whenever the antenna is in close proximity to a user's hand and/or head. Following detection of the capacitance change, the capacitance of the antenna may be changed by using a variable capacitor that is coupled to the sensor through a controller.

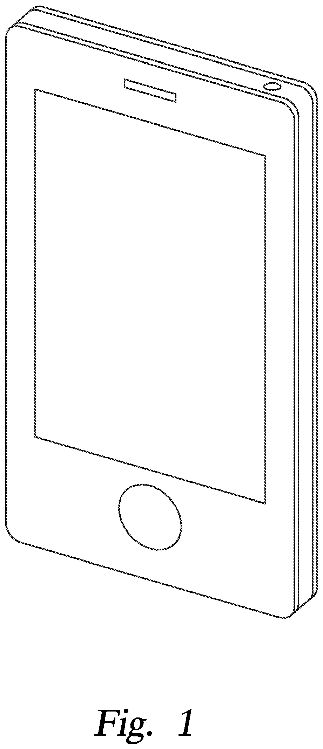

Small antennas which are suitable to be integrated in a portable radio frequency device such as the mobile phone illustration in Figure 1 are typically mounted on the top side or the back side of the mobile device, and the device acts as an active counter pole of the antenna. Such small antennas are typically designed as variations of simple monopole antenna, using forms such as (planar) inverted F antenna (P)IFA. The pattern of such antennas can be modified in order to adapt to the mechanical constraints of the device while maintaining its radiating characteristics.

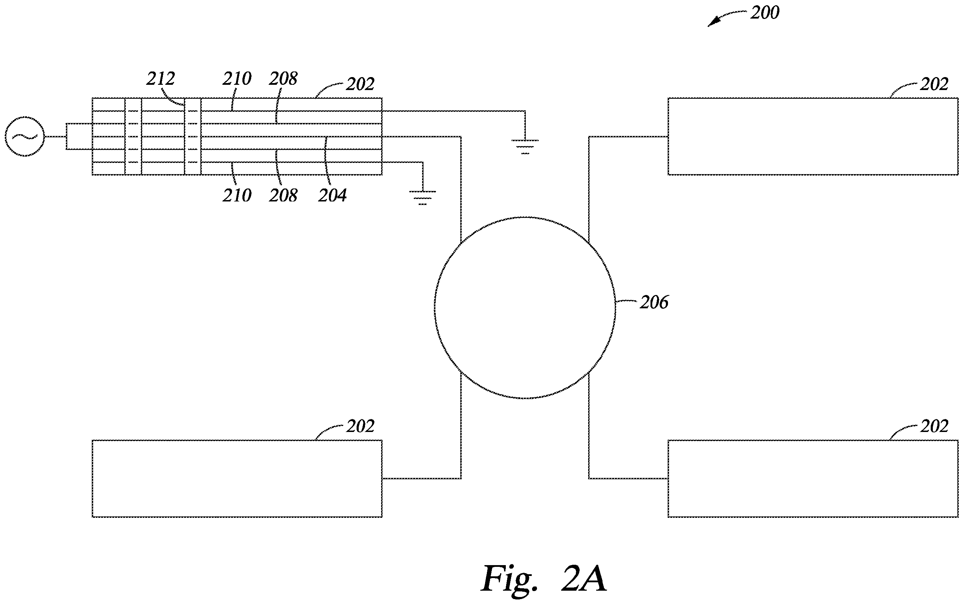

Figure 2A is a schematic illustration of a digital variable capacitor (DVC) 200 according to one embodiment. The DVC 200 includes a plurality of cavities 202. While only one cavity 202 is shown in detail, it is to be understood that each cavity 202 may have a similar configuration, although the capacitance for each cavity 202 may be different.

Each cavity 202 has a RF electrode 204 which is coupled to an RF connector/solder bump 206. Additionally, each cavity 202 has one or more pull-in electrodes 208 and one or more ground electrodes 210. The switching elements 212 (2 shown) are disposed over the electrodes 204, 208, 210. In fact, the switching elements 212 are electrically coupled to the ground electrodes 210. The switching elements 212 are movable to various spacing from the RF electrode 204 due to electrically current applied to the pull-in electrodes 208.

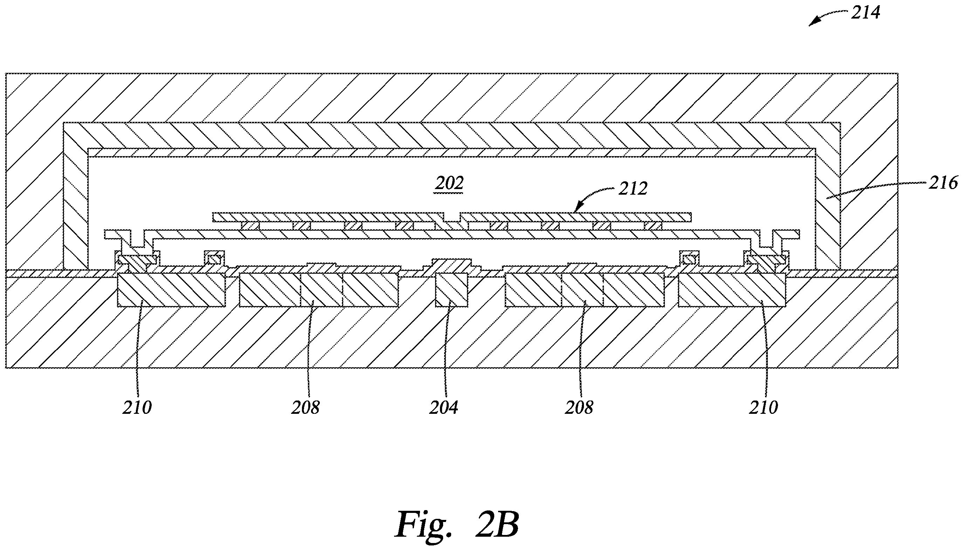

Figure 2B is a schematic illustration of a MEMS device 214. The MEMS device 214 includes the electrodes 204, 208, 210 and the switching element 212 which is disposed in the cavity 200 and movable from a position close to the RF electrode 204 (referred to as the Cₘₐₓ position) and a position spaced adjacent a pull-up electrode 216 (referred to as the Cₘᵢₙ position). The position of the switching elements 212 within the cavity 200 determines the capacitance for a particular cavity. By using the MEMS devices in a DVC, the antennas can be tuned as discussed herein.

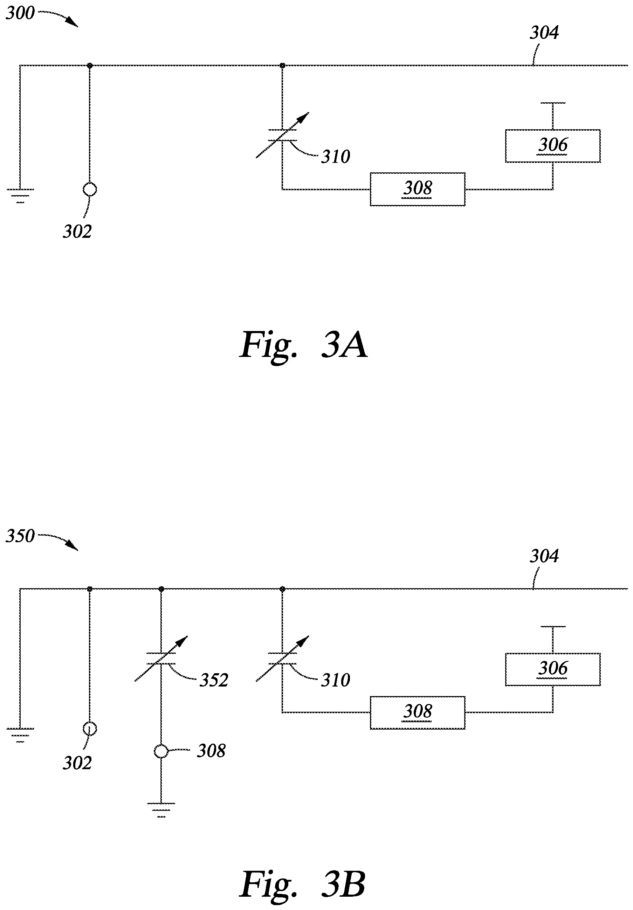

Figures 3A-3B are schematic circuit diagrams of a device having a capacitance feedback system according to embodiments of the disclosure. In Figure 3A, the device 300 includes an RF feed 302 represented by a node that is connected to an antenna 304. The capacitance of the antenna 304 is measured by a capacitive sensor 306 that is coupled to a feedback controller 308 such as a digital signal processor (DSP). The controller 308 is coupled to a first variable capacitor 310 that is coupled to the antenna 304. In one embodiment, the first variable capacitor 310 is a DVC. In operation, the antenna 304 target capacitance is set to a free-space (without head or hand influence) level. When the device is picked up, the capacitance of the antenna 304 changes from the target capacitance level. The capacitance of the antenna 304 may be changed due to proximity to a user's head or by being picked up by the user and held in the user's hand.

It is to be understood that the capacitance of the antenna 304 may change multiple times due to initially being picked up by the hand of the user, then adjusted in the hand of the user, then placed against the ear of the user, and then moved as the user is talking on the mobile device. in other words, the capacitance of the antenna 304 may continuously change when the mobile device is in operation.

The sensor 306 detects the total capacitance of the antenna 304. The detected capacitance value is fed to the controller 308 which calculates the change from target capacitance and then adjusts the capacitance of capacitor 310 by a proportional amount. By adjusting the capacitance of capacitor 310, the total capacitance of the antenna 304 is changed back to the target capacitance level.

It is to be understood that the capacitance of the capacitor 310 may vary continuously due to the detected change in the capacitance of the antenna 304 changing continuously as the mobile device is in use.

In the embodiment shown in Figure 3B, a second capacitor 352 is coupled to the antenna 304. The second capacitor may comprise a variable capacitor such as a DVC. In operation, the target capacitance value of the antenna 304 is adjusted when setting the capacitance of the second capacitor 352 for instance when a change in operating band of the antenna is desired. Then, when a user picks up the mobile device or places the device closer to the head of the user, the capacitance of the antenna 304 changes from the adjusted target capacitance, which includes the capacitance of the second capacitor 352, to a second capacitance due to the interference of the head and/or hand with the antenna. The sensor 306 then detects the change in capacitance of the antenna 304 from the adjusted target capacitance including the second capacitor 352. The controller 308 then changes the capacitance of the first capacitor 310 so that the antenna 304 total capacitance returns to the adjusted target value including the value of the second capacitor 352. If the value of the second capacitor 352 changes, for instance due to a change in operating band of the antenna, and hence, the capacitance of the antenna 304 changes from a first capacitance to a third capacitance, the controller 308 receives the information and further adjusts the target capacitance of the antenna 304. Then, when the user picks up the mobile device or moves the mobile device to a location close to the head of the user, the capacitance of the antenna 304 changes from the third capacitance to a fourth capacitance. The sensor 306 detects the capacitance of the antenna 304 and the controller 308 then changes the capacitance of the first capacitor 310 to thus change the capacitance of the antenna 304 to the third capacitance. It is to be noted that the second capacitor 352 operates independently of the first capacitor 310.

The embodiments discussed herein disclose a method and device for compensating for the capacitance change in the antenna that occurs whenever a user picks up a mobile device or moves a mobile device to close proximity to the user's head. Once the capacitance of the antenna changes, the change is detected and the new capacitance is compared to the target antenna capacitance. If the measured capacitance is different from the target capacitance, then a variable capacitor coupled to the antenna is adjusted to change the capacitance of the variable capacitor, which then changes the capacitance of the antenna back to the target capacitance. Based upon the embodiments discussed herein, a mobile device can operate properly when picked up by a user or moved closer to the user's head.

## Claims

1. A device, comprising:
a first antenna (304);
an RF source coupled to the first antenna (304);
a capacitive sensor (306) capable of detecting a capacitance of the antenna (304), the capacitive sensor (306) configured to detect a change of the capacitance of the antenna (304) from a preselected target value; a feedback controller (308) coupled to the capacitive sensor (306); and
a first variable capacitor (310) coupled to the antenna (304) and to the feedback controller (308), wherein the first variable capacitor (310), the feedback controller (308) and the capacitive sensor (306) are connected in series with the antenna (304) and in that order from the antenna (304), and wherein the feedback controller (308) is configured to continuously change the capacitance of the first variable capacitor (310) in response to the change of the capacitance of the antenna (304) so that the adjusted capacitance of the antenna (304) returns to the preselected target value.

2. The device of claim 1, wherein the first variable capacitor (310) is a digital variable capacitor (200).

3. The device of claim 2, wherein the digital variable capacitor (200) includes a plurality of MEMS devices (214).

4. The device of claim 3, wherein the antenna (304) is coupled to ground.

5. The device of claim 4, wherein the antenna (304) is coupled to an RF feed (302).

6. The device of claim 5, further comprising a second capacitor (352) coupled to the antenna (304).

7. The device of claim 6, wherein the second capacitor (352) is a digital variable capacitor (200).

8. The device of claim 7, wherein the digital variable capacitor (200) comprises a plurality of MEMS (214).

9. The device of claim 1, further comprising a second capacitor (352) coupled to the antenna (304).

10. The device of claim 9, wherein the second capacitor (352) is a digital variable capacitor (200) that comprises a plurality of MEMS (214).

11. A method, comprising:
detecting a change in capacitance of an antenna (304) from a preselected target value to a second capacitance using a capacitive sensor (306) that is disposed in a device; and
changing capacitance in a first variable capacitor (310) based upon feedback from the capacitive sensor (306), wherein changing capacitance in the first variable capacitor (310) changes the capacitance of the antenna (304) from the second capacitance to the preselected target value, wherein the first variable capacitor (310), a feedback controller (308) and the capacitive sensor (306) are connected in series with the antenna (304) and in that order from the antenna (304), and wherein the feedback controller (308) is configured to continuously change the capacitance of the first variable capacitor (310) in response to the change of the capacitance of the antenna (304) so that the adjusted capacitance of the antenna (304) returns to the preselected target value.

12. The method of claim 11, further comprising:
changing the preselected target value of the capacitance of the antenna (304) from a first capacitance to a third capacitance with a second variable capacitor (352).

13. The method of claim 12, wherein the first variable capacitor (310) and the second variable capacitor (352) are digital variable capacitors (200).

14. The method of claim 13, wherein the digital variable capacitors (200) each comprise a plurality of MEMS (214).

15. The method of claim 14, wherein the second variable capacitor (352) is coupled to the antenna (304).

16. The method of claim 15, wherein the antenna (304) is coupled to ground.

17. The method of claim 16, wherein the antenna (304) is coupled to an RF feed (302).

18. The method of claim 11, wherein the first variable capacitor (310) is a digital variable capacitor (200) having a plurality of MEMS (214).

## Patentansprüche

1. Vorrichtung, die Folgendes beinhaltet:
eine erste Antenne (304);
eine HF-Quelle, die mit der ersten Antenne (304) gekoppelt ist;
einen kapazitiven Sensor (306), der eine Kapazität der Antenne (304) detektieren kann, wobei der kapazitive Sensor (306) konfiguriert ist, eine Änderung der Kapazität der Antenne (304) von einem vorgewählten Zielwert zu detektieren;
einen Feedback-Regler (308), der mit dem kapazitiven Sensor (306) gekoppelt ist; und
einen ersten variablen Kondensator (310), der mit der Antenne (304) und dem Feedback-Regler (308) gekoppelt ist, wobei der erste variable Kondensator (310), der Feedback-Regler (308) und der kapazitive Sensor (306) in Serie mit der Antenne (304) und in dieser Reihenfolge von der Antenne (304) verbunden sind und wobei der Feedback-Regler (308) konfiguriert ist, die Kapazität des ersten variablen Kondensators (310) als Reaktion auf die Änderung der Kapazität der Antenne (304) kontinuierlich zu ändern, sodass die angepasste Kapazität der Antenne (304) auf den vorgewählten Zielwert zurückkehrt.

2. Vorrichtung gemäß Anspruch 1, wobei der erste variable Kondensator (310) ein digitaler, variabler Kondensator (200) ist.

3. Vorrichtung gemäß Anspruch 2, wobei der digitale, variable Kondensator (200) eine Vielzahl von MEMS-Vorrichtungen (214) umfasst.

4. Vorrichtung gemäß Anspruch 3, wobei die Antenne (304) mit der Masse gekoppelt ist.

5. Vorrichtung gemäß Anspruch 4, wobei die Antenne (304) mit einer HF-Einspeisung (302) gekoppelt ist.

6. Vorrichtung gemäß Anspruch 5, die ferner einen zweiten Kondensator (352) beinhaltet, der mit der Antenne (304) gekoppelt ist.

7. Vorrichtung gemäß Anspruch 6, wobei der zweite Kondensator(352) ein digitaler, variabler Kondensator (200) ist.

8. Vorrichtung gemäß Anspruch 7, wobei der digitale, variable Kondensator (200) eine Vielzahl von MEMS (214) beinhaltet.

9. Vorrichtung gemäß Anspruch 1, die ferner einen zweiten Kondensator (352) beinhaltet, der mit der Antenne (304) gekoppelt ist.

10. Vorrichtung gemäß Anspruch 9, wobei der zweite Kondensator(352) ein digitaler, variabler Kondensator (200) ist, der eine Vielzahl von MEMS (214) beinhaltet.

11. Verfahren, das Folgendes beinhaltet:
Detektieren einer Änderung der Kapazität einer Antenne (304) von einem vorgewählten Zielwert auf eine zweite Kapazität unter Verwendung eines kapazitiven Sensors (306), der in einer Vorrichtung angeordnet ist; und
Ändern der Kapazität in einem ersten variablen Kondensator (310) basierend auf Feedback vom kapazitiven Sensor (306), wobei das Ändern der Kapazität im ersten variablen Kondensator (310) die Kapazität der Antenne (304) von der zweiten Kapazität auf den vorgewählten Zielwert ändert,
wobei der erste variable Kondensator (310), ein Feedback-Regler (308) und der kapazitive Sensor (306) in Serie mit der Antenne (304) und in dieser Reihenfolge von der Antenne (304) verbunden sind und wobei der Feedback-Regler (308) konfiguriert ist, die Kapazität des ersten variablen Kondensators (310) als Reaktion auf die Änderung der Kapazität der Antenne (304) kontinuierlich zu ändern, sodass die angepasste Kapazität der Antenne (304) auf den vorgewählten Zielwert zurückkehrt.

12. Verfahren gemäß Anspruch 11, das ferner Folgendes beinhaltet:
Ändern des vorgewählten Zielwerts der Kapazität der Antenne (304) von einer ersten Kapazität auf eine dritte Kapazität mit einem zweiten variablen Kondensator (352).

13. Verfahren gemäß Anspruch 12, wobei der erste variable Kondensator (310) und der zweite variable Kondensator (352) digitale, variable Kondensatoren (200) sind.

14. Verfahren gemäß Anspruch 13, wobei die digitalen, variablen Kondensatoren (200) jeweils eine Vielzahl von MEMS (214) beinhalten.

15. Verfahren gemäß Anspruch 14, wobei der zweite variable Kondensator (352) mit der Antenne (304) gekoppelt ist.

16. Verfahren gemäß Anspruch 15, wobei die Antenne (304) mit der Masse gekoppelt ist.

17. Verfahren gemäß Anspruch 16, wobei die Antenne (304) mit einer HF-Einspeisung (302) gekoppelt ist.

18. Verfahren gemäß Anspruch 11, wobei der erste variable Kondensator (310) ein digitaler, variabler Kondensator (200) ist, der eine Vielzahl von MEMS (214) aufweist.

## Revendications

1. Dispositif comprenant :
une première antenne (304) ;
une source RF couplée à cette première antenne (304) ;
un capteur capacitif (306) capable de détecter une capacité de l'antenne (304), ce capteur capacitif (306) étant configuré de façon à détecter un changement de la capacité de l'antenne (304) à partir d'une valeur cible présélectionnée ;
un régulateur à réaction (308) couplé au capteur capacitif (306) ; et
un premier condensateur variable (310) couplé à l'antenne (304) et au régulateur à réaction (308), le premier condensateur variable (310), le régulateur à réaction (308) et le capteur capacitif (306) étant connectés en série avec l'antenne (304) et, dans cet ordre depuis l'antenne (304), et le régulateur à réaction (308) étant configuré de façon à changer de façon continue la capacité du premier condensateur variable (310) en réponse au changement de la capacité de l'antenne (304) de manière à ce que la capacité modifiée de l'antenne (304) retourne à la valeur cible présélectionnée.

2. Dispositif selon la revendication 1, dans lequel le premier condensateur variable (310) est un condensateur variable numérique (200).

3. Dispositif selon la revendication 2, dans lequel ce condensateur variable numérique (200) comprend une pluralité de dispositifs MEMS (214).

4. Dispositif selon la revendication 3, dans lequel l'antenne (304) est couplée à la masse.

5. Dispositif selon la revendication 4, dans lequel l'antenne (304) est couplée à une alimentation RF (302).

6. Dispositif selon la revendication 5, comprenant en outre un deuxième condensateur (352) couplé à l'antenne (304).

7. Dispositif selon la revendication 6, dans lequel le deuxième condensateur (352) est un condensateur variable numérique (200).

8. Dispositif selon la revendication 7, dans lequel ce condensateur variable numérique (200) comprend une pluralité de dispositifs MEMS (214).

9. Dispositif selon la revendication 1, comprenant en outre un deuxième condensateur (352) couplé à l'antenne (304).

10. Dispositif selon la revendication 9, dans lequel ce deuxième condensateur (352) est un condensateur variable numérique (200) qui comprend une pluralité de dispositifs MEMS (214).

11. Procédé comprenant :
la détection d'un changement de capacité d'une antenne (304) d'une valeur cible présélectionnée à une deuxième capacité en utilisant un capteur capacitif (306) qui est disposé dans un dispositif ; et
le changement de la capacité dans un premier condensateur variable (310) en se basant sur la réaction provenant du capteur capacitif (306), le changement de la capacité dans le premier condensateur variable (310) changeant la capacité de l'antenne (304) de la deuxième capacité à la valeur cible présélectionnée,
le premier condensateur variable (310), un régulateur à réaction (308) et le capteur capacitif (306) étant connectés en série avec l'antenne (304) et, dans cet ordre, depuis l'antenne (304), et le régulateur à réaction (308) étant configuré de façon à changer de façon continue la capacité du premier condensateur variable (310) en réponse au changement de la capacité de l'antenne (304) de manière à ce que la capacité modifiée de l'antenne (304) retourne à la valeur cible présélectionnée.

12. Procédé selon la revendication 11, comprenant en outre :
le changement de la valeur cible présélectionnée de la capacité de l'antenne (304) d'une première capacité à une troisième capacité avec un deuxième condensateur variable (352).

13. Procédé selon la revendication 12, dans lequel le premier condensateur variable (310) et le deuxième condensateur variable (352) sont des condensateurs variables numériques (200).

14. Procédé selon la revendication 13, dans lequel ces condensateurs variables numériques (200) comprennent chacun une pluralité de dispositifs MEMS (214).

15. Procédé selon la revendication 14, dans lequel le deuxième condensateur variable (352) est couplé à l'antenne (304).

16. Procédé selon la revendication 15, dans lequel l'antenne (304) est couplée à la masse.

17. Procédé selon la revendication 16, dans lequel l'antenne (304) est couplée à une alimentation RF (302).

18. Procédé selon la revendication 11, dans lequel le premier condensateur variable (310) est un condensateur variable numérique (200) ayant une pluralité de dispositifs MEMS (214).
